(19) Europäisches Patentamt
European Patent Office
Office européen des brevets

(11) EP 4 782 853 A1

(12) **EUROPEAN PATENT APPLICATION**

(43) Date of publication:
29.07.2026  Bulletin 2026/31

(21) Application number: 25218259.7

(22) Date of filing: 25.11.2025

(51) International Patent Classification (IPC):
*G01R 31/389* (2019.01)    *G01R 31/392* (2019.01)

(52) Cooperative Patent Classification (CPC):
**G01R 31/392; G01R 31/389**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority:  28.01.2025  US 202519038911

(71) Applicant: **TOYOTA MOTOR ENGINEERING & MANUFACTURING NORTH AMERICA, INC.**
**Plano, TX 75024 (US)**

(72) Inventor: **ISHIGAKI, Masanori**
**Plano, Texas 75024 (US)**

(74) Representative: **Winter, Brandl - Partnerschaft mbB**
**Alois-Steinecker-Straße 22**
**85354 Freising (DE)**

(54) **SYSTEMS AND METHODS FOR ESTIMATING A SAFETY STATE OF A USED BATTERY USING DERIVATIVE COMPUTATIONS**

(57)    Systems, methods, and other embodiments described herein relate to estimating a safety state of a used battery for reuse and recycle applications through utilizing derivative computations of impedance. In one embodiment, a method includes identifying a temperature and a state of charge (SOC) by testing equipment to measure impedance for a used battery from a vehicle. The method also includes removing interference sources by computing first derivatives of real-parts from the impedance and factoring the temperature and the SOC, and the testing equipment measures the impedance. The method also includes estimating a safety state and a physical degradation for the used battery from changes of the first derivatives within a frequency band. The method also includes upon the safety state satisfying a parameter, draw power from the used battery by a device during a reuse operation.

FIG. 2B

**Description**

TECHNICAL FIELD

The subject matter described herein relates, in general, to estimating a safety state of a used battery, and, more particularly, to estimating the safety state of the used battery for reuse and recycling applications.

BACKGROUND

A vehicle drawing power from a traction battery is a clean and sustainable alternative to burning fossil fuels that reduces greenhouse emissions. Furthermore, electric vehicles (EVs) powered by batteries can lower fuel and maintenance costs that improve the economics for consumers. Traction batteries have a limited lifespan and disposal can be harmful to the environment due to metallic components. For instance, lithium-ion batteries can leak toxic chemicals like cobalt, nickel, and manganese into the soil and water. These batteries can also cause fires in landfills and recycling facilities that increase air pollution. As such, systems implementing traction batteries in an EV exhibit harmful environmental consequences at the end-of-life (EoL).

In various implementations, systems can remanufacture a battery at the EoL for certain applications. For instance, a traction battery produces sufficient power as a backup source for a house. However, chemical breakdown and internal degradation to the traction battery can limit reuse applications. In one example, chemical plating occurs during battery charging when lithium ions deposit as metallic lithium on an anode. Plating can significantly degrade battery performance by reducing the available lithium for energy storage, increase internal resistance, and cause safety hazards from short circuits. Furthermore, systems detecting lithium plating encounter difficulties since the phenomenon occurs microscopically within cells that are embedded within the traction battery. Detection systems also typically demand specialized and expensive equipment for diagnosing plating within a battery cell. Therefore, reusing a traction battery after retiring from an EV has challenges associated with chemical defects that are complex and costly to detect, thereby reducing applications and increasing hazards for reuse opportunities.

SUMMARY

In one embodiment, example systems and methods relate to estimating a safety state of a used battery for reuse and recycle applications through utilizing derivative computations of impedance. In various implementations, systems reuse a battery pack implemented in an electric vehicle (EV) as an energy source for a powertrain upon retirement. However, chemical degradation from recharging and physical damage during travel (e.g., collisions, road debris, etc.) can limit applications for the battery pack due to safety. At times, a system recycles a battery pack that has unknown defective internally which is difficult to diagnose unlike external wear and damage. For instance, a battery pack within an EV having increased charging rates and exposure to low temperatures experiences plating within an embedded cell. Plating can involve forming a metallic layer on an anode surface from improper intercalation of lithium ions into anode material and the lithium ions accumulating on the anode surface. Furthermore, systems detecting plating within the battery pack can involve dissembling modules having battery cells for access by equipment that damages sensitive components. For example, disassembling the battery pack for diagnosing plating by scanning electron microscopy (SEM) and nuclear magnetic resonance (NMR) harms internal sensors, controllers, and cell packaging. Thus, chemical degradation and defects cause unsafe conditions for reusing a battery and detecting the conditions can involve disassembly, thereby increasing costs and complexity for reuse.

Therefore, in one embodiment, an estimation system predicts a safety state of a module within a used battery for reuse and repurposing applications using first derivative computations of real values associated with impedance measurements. Here, the module can be located within a battery pack of an EV. The module can include multiple cells, a cell array, etc., exhibiting potentially degraded and defective states from powering a device (e.g., a vehicle). In one approach, the estimation system removes interference sources within the module that are linear and constant using non-invasive equipment and external measurements, thereby avoiding damage to internal cells and sensitive equipment of the used battery. These interference sources can exhibit first derivative values from the impedance measurements that are unchanged and negligible (e.g., zero). Furthermore, the estimation system measures the impedance at a frequency band according to the internal architecture of the used battery where the interference sources are dominant and evident. As such, the estimation system can accurately estimate safety concerns caused by degradation (e.g., metallic plating) of cells within the used battery (e.g., a lithium-ion battery) from the first derivative of real values between various frequency points. In this way, the estimation system reliably and safely detects degradation and defects within a used battery non-invasively and identifies reuse applications for the used battery that reduce environmental waste.

In one embodiment, an estimation system to estimate a safety state of a used battery for reuse and recycle applications through utilizing derivative computations of impedance is disclosed. The estimation system includes a memory including instructions that, when executed by a processor, cause the processor to identify a temperature and a state of charge (SOC) by testing equipment to measure impedance for a used battery from a vehicle. The instructions also include instructions to remove interference sources by computing first derivatives of real-parts from the impedance and factoring the temperature and the SOC, and the testing equipment measures the impedance. The instructions also include instructions to estimate a safety state and a physical degradation for the used battery from changes of the first derivatives within a frequency band. The instructions also include instructions to draw power from the used battery by a device during a reuse operation upon the safety state satisfying a parameter.

In one embodiment, a non-transitory computer-readable medium for estimating a safety state of a used battery for reuse and recycle applications through utilizing derivative computations of impedance and including instructions that when executed by a processor cause the processor to perform one or more functions is disclosed. The instructions include instructions to identify a temperature and a SOC by testing equipment to measure impedance for a used battery from a vehicle. The instructions also include instructions to remove interference sources by computing first derivatives of real-parts from the impedance and factoring the temperature and the SOC, and the testing equipment measures the impedance. The instructions also include instructions to estimate a safety state and a physical degradation for the used battery from changes of the first derivatives within a frequency band. The instructions also include instructions to draw power from the used battery by a device during a reuse operation upon the safety state satisfying a parameter.

In one embodiment, a method for estimating a safety state of a used battery for reuse and recycle applications through utilizing derivative computations of impedance is disclosed. In one embodiment, the method includes identifying a temperature and a SOC by testing equipment to measure impedance for a used battery from a vehicle. The method also includes removing interference sources by computing first derivatives of real-parts from the impedance and factoring the temperature and the SOC, and the testing equipment measures the impedance. The method also includes estimating a safety state and a physical degradation for the used battery from changes of the first derivatives within a frequency band. The method also includes, upon the safety state satisfying a parameter, drawing power from the used battery by a device during a reuse operation.

BRIEF DESCRIPTION OF THE DRAWINGS

The accompanying drawings, which are incorporated in and constitute a part of the specification, illustrate various systems, methods, and other embodiments of the disclosure. It will be appreciated that the illustrated element boundaries (e.g., boxes, groups of boxes, or other shapes) in the figures represent one embodiment of the boundaries. In some embodiments, one element may be designed as multiple elements or multiple elements may be designed as one element. In some embodiments, an element shown as an internal component of another element may be implemented as an external component and vice versa. Furthermore, elements may not be drawn to scale.

FIG. 1 illustrates one embodiment of an estimation system that is associated with estimating a safety state of a used battery for reuse and recycle applications through derivative computations of impedance. FIGS. 2A and 2B illustrate examples of detecting plating and determining a residual value and reuse applications for a used battery.
FIG. 3A and 3B illustrate examples of interference sources the estimation system can mitigate using first derivative computations.
FIG. 4 illustrates another embodiment of detecting plating and determining a residual value using first derivative computations and multiple thresholds.
FIG. 5 illustrates one embodiment of a method that is associated with estimating a safety state and degradation for the used battery from changes of first derivatives over a frequency band.

DETAILED DESCRIPTION

Systems, methods, and other embodiments associated with estimating a safety state of a used battery for reuse and recycle applications through utilizing derivative computations of impedance are disclosed herein. In various implementations, systems testing internal conditions (e.g., metallic plating) for reusing batteries involves measurements acquired with complex equipment. Metallic plating can involve forming a superficial layer on an anode from improper intercalation of ions into anode material. In the case of a lithium battery powering an electric vehicle (EV), the superficial layer is lithium ions accumulating on the anode surface that interferes with current output and diminishes overall power generation. Systems can encounter difficulties detecting plating and other degradation for a used battery having tightly integrated hardware and battery cells unlike a short within internal circuitry. Furthermore, systems using spectroscopy equipment can demand direct access to battery cells and terminals within the used battery to detect plating and other degradation sources. Tasks associated with the access can permanently damage the used battery while dissembling modules to probe the battery cells, thereby precluding reuse applications. In another approach, systems using non-destructive techniques such as ultrasonic inspection involve complex and sophisticated equipment that hinders testing adaptation. Therefore, systems testing a used battery for physical degradation and plating encounter difficulties with detection technologies involving complex equipment and invasive disassembly, thereby reducing opportunities for reuse applications and increasing waste.

Therefore, in one embodiment, an estimation system removes and magnifies changes of interference sources through identifying frequency characteristics from aging materials and cell architecture within a used battery using first derivative computations of impedance. The estimation system can exploit that high-frequency (HF) electrochemical impedance spectroscopy (EIS) exhibits decreasing real-part impedance within selected frequency bands. Selection of the frequency band can factor a cell layout and chemical properties of the used battery. In one approach, the frequency band is above a frequency having increased chemical breakdown and an ion response (e.g., lithium-ion) that is elevated and robust for testing the used battery. Furthermore, the estimation system identifies and factors a temperature and a state of charge (SOC) to measure impedance for the used battery such that first derivative computations from real-parts of the impedance enhance and elevate plating activities existing within a module. The first derivative computations also remove certain interference sources (e.g., contact interference, inductive interference, etc.) that are unchanged and negligible (e.g., zero) within the frequency band for a cell, a cell array, etc., from a module level. This may allow the estimation system to identify plating, degradation, etc., of a terminal within the used battery externally and involve minimal disassembly using changes of first derivative values for impedance within the frequency band. The impedance can also be measured using non-invasive equipment, thereby improving reuse yield through reducing testing damage.

As another enhancement, the estimation system executes second derivative computations of impedance (e.g., real-parts of impedance) over a frequency band. This allows diagnosing internal plating at the module level while removing and mitigating additional interference sources more than first derivative operations. Additionally, the estimation system can also output a safety state indicating metallic plating and a residual value (e.g., remaining functionality, power reliability, etc.) about the used battery at the module level while avoiding impedance tracking. The safety state can involve extracting operating qualities over certain safety-related features of the used battery (e.g., SOC, temperature, induction, etc.). Here, impedance tracking can demand a system measuring and comparing impedance using internal sensor data that is unavailable from third-party manufacturers. Furthermore, impedance tracking can also involve accessing manufacturing details and schematics that are proprietary. Accordingly, the estimation system can reliably and accurately detect the safety state (e.g., metallic plating) of cells within the used battery from first derivative computations between various points along the frequency band while using non-invasive measures that also reduce testing complexity and component damage.

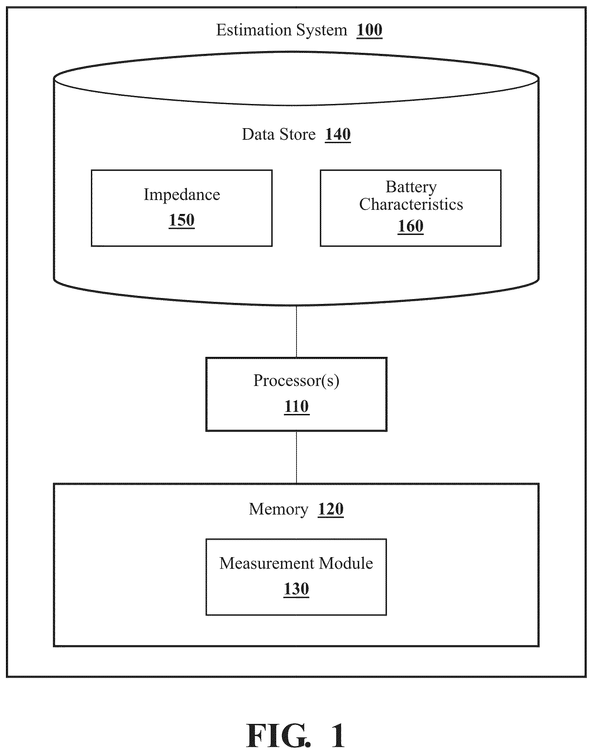

In certain implementations, the systems illustrated in FIGS. 1-4 also include various elements. It will be understood that in various embodiments, the systems may have less than the elements shown in FIGS. 1-4. The systems can have any combination of the various elements shown in FIGS. 1-4. Furthermore, the systems can have additional elements to those shown in FIGS. 1-4. In some arrangements, the systems may be implemented without one or more of the elements shown in FIGS. 1-4. While the various elements are shown as being located within the systems in FIGS. 1-4, it will be understood that one or more of these elements can be located external to the systems. Furthermore, the elements shown may be physically separated by large distances. Additionally, it will be appreciated that for simplicity and clarity of illustration, where appropriate, reference numerals have been repeated among the different figures to indicate corresponding or analogous elements. In addition, the discussion outlines numerous specific details to provide a thorough understanding of the embodiments described herein. Those of skill in the art, however, will understand that the embodiments described herein may be practiced using various combinations of these elements.

With reference to FIG. 1, one embodiment of an estimation system 100 that is associated with estimating a safety state of a used battery for reuse and recycle applications through derivative computations of impedance is illustrated. In one approach, systems monitoring, detecting, etc., internal growth of Li-metal deposition is vital for evaluating a state of safety (SOS) of lithium-ion batteries. The internal growth is a factor of reducing thermal runaway temperature of lithium-ion batteries, thereby increasing reuse applications that are safe. Here, the estimation system 100 can identify a temperature and a SOC by testing equipment to optimally measure impedance for a used battery from a vehicle associated with internal state detections. As such, a measurement module 130 of testing equipment measures the impedance within a certain frequency band that exhibits and enhances interference sources. The estimation system 100 can remove the interference sources by computing first derivatives of real-parts from the impedance and factoring the temperature and the SOC. Furthermore, the estimation system 100 estimates a safety state and a degradation (e.g., a chemical degradation, a physical degradation, etc.) for the used battery from changes of the first derivatives within a frequency band. Upon the safety state satisfying a parameter, the estimation system 100 can reuse the used battery to power a device. For instance, the device draws power from the used battery during a reuse operation (e.g., backup generator).

In one embodiment, the estimation system 100 includes a memory 120 that stores the measurement module 130. The memory 120 is a random-access memory (RAM), a read-only memory (ROM), a hard-disk drive, a flash memory, or other suitable memory for storing the measurement module 130. The measurement module 130 is, for example, computer-readable instructions that when executed by the processor(s) 110 cause the processor(s) 110 to perform the various functions disclosed herein.

In FIG. 1, the measurement module 130 generally includes instructions that function to control the processor(s) 110 to receive data inputs from one or more sensors of the testing equipment. For instance, the testing equipment measures impedance using hardware that apply a minimal alternating current (AC) signal into a module, cell, etc., and measures the response. Such testing equipment can precisely output detailed information about the internal resistance and reactance of a battery, such as a high-voltage battery used by an EV.

Moreover, in one embodiment, the estimation system 100 includes a data store 140. In one embodiment, the data store 140 is a database. The database is, in one embodiment, an electronic data structure stored in the memory 120 or another data store and that is configured with routines that can be executed by the processor(s) 110 for analyzing stored data, providing stored data, organizing stored data, and so on. Thus, in one embodiment, the data store 140 stores data used by the measurement module 130 in executing various functions. In one embodiment, the data store 140 includes impedance 150 and battery characteristics 160. The impedance 150 can include a measure of the opposition to electrical flow expressed using complex-valued generalization and Ohm (Ω) units. As such, impedance is similar to resistance in direct current (DC) systems. In AC systems, impedance incorporates reactance due to frequency-dependent contributions from capacitance and inductance. As such, impedance in an AC system is still measured in Ω units by the equation $Z = V/I$ having $V$ and $I$ that are frequency-dependent.

The estimation system 100 includes testing equipment that measures impedance at a module level for a used battery and executes computations involving first derivatives of the impedance. As further explained below, this allows removing interference sources having first derivative properties for impedance that are unchanged and negligible (e.g., zero). This also allows estimating a safety state and degradation (e.g., a chemical degradation, a physical degradation, etc.) for one or more cells within a module of a used battery without invasive dissembling and expensive equipment, thereby reducing system complexity.

The battery characteristics 160 can include the safety state that indicates plating within a cell, a cell array, a module, etc., internal to the used battery and a frequency band where the plating is prominent. The safety state can involve extracting operating qualities over certain safety-related features of the used battery (e.g., SOC, temperature, induction, etc.). Plating can involve forming a metallic layer on an anode surface of the cell from improper intercalation of lithium ions into anode material and the lithium ions accumulating on the anode surface. Here, the frequency band can be above a frequency having increased chemical breakdown and an ion response that is elevated when testing the used battery. The battery characteristics 160 can also include a parameter associated with the safety state indicating that one of a cell and the module internally within the used battery has undetected plating on a surface of an anode associated with a threshold (e.g., a current output, a voltage output, etc.).

In another approach, the battery characteristics 160 includes an SOC that is one of a charge level and a discharge level associated with chemical degradation. Furthermore, the battery characteristics 160 can include a functionality state for the used battery using the safety state and a weighting factor. For instance, the functionality state can be a residual value of the used battery as a power source in a reuse application. As further explained below, the residual value or functionality state can be directly correlated with the safety state for the used battery.

In FIG. 1, the estimation system 100 and the measurement module 130 include instructions that cause the processor 110 to detect physical and chemical changes about the internal state of a battery (e.g., a lithium-ion battery) from impedance measurements. In one approach, a frequency band for impedance measurements exceeds a frequency (e.g., 100 Hz, 1 kHz, 1 MHz, etc.) where the ion response inside the battery is dominant. This allows the estimation system 100 to accurately diagnose causes of impedance changes from impedance values and a first derivative for a frequency, such as variable frequencies $f_1$ to $f_2$. A diagnosis can include one of a safety state, the existence of lithium metal deposition, lithium plating inside at least one cell of a battery, and a residual value. For example, the residual value is a state of function (SOF), a state of functionality, etc., associated with a used battery for reuse applications. The residual value exceeding a minimal parameter, threshold, etc., can indicate that one or more cells within the used battery exhibit sparse plating or lack metallic plating, thereby increasing opportunities for reuse rather than recycling and creating waste. Otherwise, the residual value may indicate that the used battery is unsuitable and unsafe for reuse opportunities and the used battery should be recycled.

Moreover, different degrees of the residual value can also indicate available applications for reuse. For instance, an average residual value indicates that the used battery can be reliably used as a backup source for a house. This application may have reduced demands for safety and quality of service (QoS). Critical applications can demand a residual value that is elevated for the used battery. This can include the used battery being a main power source for hospitals, powering medical equipment, a power source for a chemical plant, etc. In another approach, the SOF weights a SOS with a variable $\alpha$ and forms Equation (1):

$$SOF = \alpha \, x \, SOS. \quad \text{Equation (1)}$$

Here, the variable $\alpha$ is a weighting factor that can depend upon one of a battery chemistry, a cellular structure, casing material, application environment, usage environment (e.g., an electric vehicle), etc. As such, the variable $\alpha$ can incorporate and factor additional context to SOF for the used battery, thereby improving reuse determinations. For example, the estimation system 100 computes a functionality state, SOF, etc., for the used battery using the safety state and the weighting factor, and the functionality state is a residual value of the used battery as a power source in a reuse application. In this way, the estimation system 100 can reliably output one of a safety state that indicates degradation such as metallic plating and a residual value for the used battery. This allows related systems to identify that the used battery is suitable for reuse and target particular applications. Otherwise, the systems generate a recycling plan from the output since the used battery is defective and worn beyond repair.

The estimation system 100 identifying an optimal temperature, the SOC, and impedance for detecting the safety state and the residual value can include additional approaches. For instance, the estimation system 100 measuring impedance at target temperatures and SOCs parameters improves the effectiveness of detecting degradation and computing a safety state and a residual value using first derivative computations. These parametric targets can depend upon the internal architecture and chemistry profile of a used battery. The estimation system 100 can adapt these parametric targets for reuse applications during impedance measurement involving the used battery that further improve computational accuracy.

Moreover, in another approach, the estimation system 100 selects a frequency band according to a cell layout and internal architecture (e.g., cylindrical cells, stacked sheets, etc.) of a used battery. As previously explained, the frequency band can be associated with the testing equipment measuring impedance from a used battery when the ion response internally at a cell is dominant. Furthermore, the estimation system 100 and the measurement module 130 can filter wear interference and measurement noise (e.g., sensor interference) to the used battery using the frequency band. In this way, the estimation system 100 can at a module level diagnose causes of impedance changes from measurements and real-parts of a first derivative for a cell accurately while reducing computational complexity.

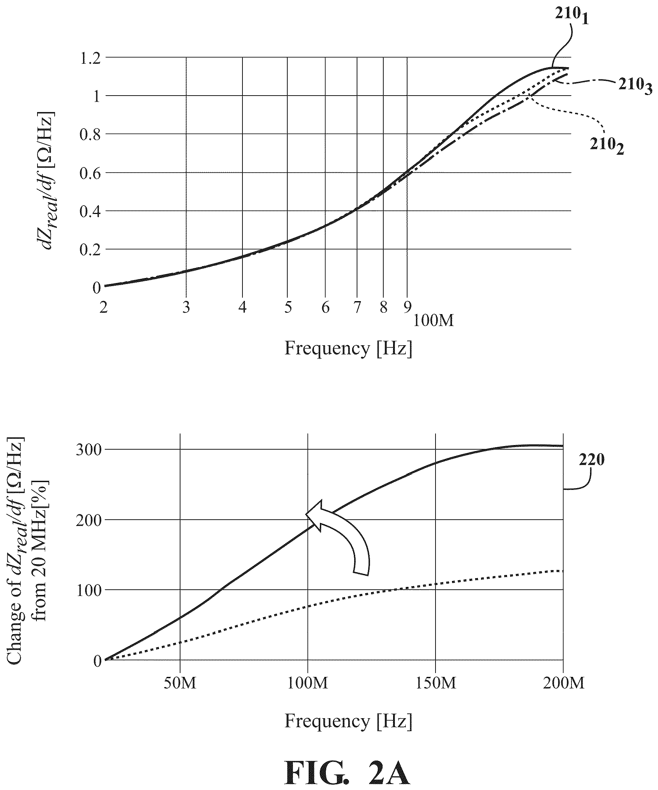

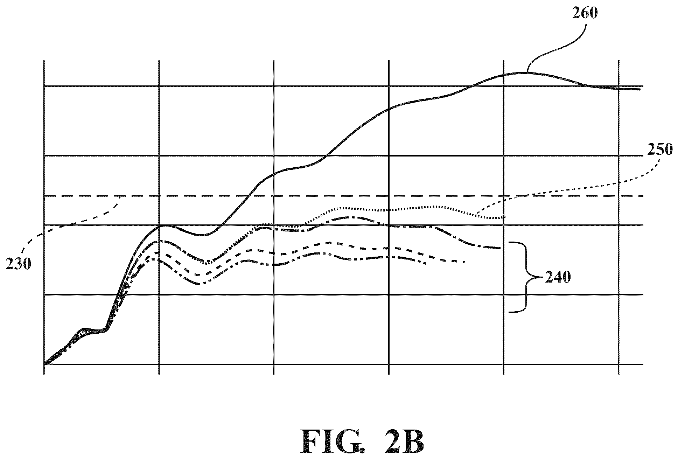

Now turning to FIGS. 2A and 2B, examples of detecting plating and determining a residual value and reuse applications for a used battery is illustrated. In one approach, the estimation system 100 computes one or more of the following first derivatives from impedance measurements associated with a used battery: a first derivative of a real-part from an impedance value, a first derivative of an imaginary-part from the impedance value, a difference between real-parts from first derivatives of impedance values among two frequency points, a difference between imaginary-parts from first derivatives of impedance values among the two frequency points, the real-part of the impedance value, and the imaginary-part of the impedance value. For instance, the two frequency points are the variable frequencies $f_1$ to $f_2$ within a

frequency band exhibiting increased chemical breakdown and an ion response associated with the used battery. This allows the estimation system 100 to reliably and non-invasively detect internal degradation and plating using first derivative computations at a module level. Furthermore, derivative computations can proceed upon filtering impedance measurements for noise by intelligently selecting the frequency band through accounting for battery architectures and profiles.

In another approach, the estimation system 100 measures impedance at target temperatures and SOCs that improve the effectiveness of detecting degradation and a residual value using first derivative computations. These targets can depend upon the internal architecture and chemistry of a used battery.

The first derivative of the real-parts from impedance exhibits properties that allow the estimation system 100 to target metal deposition and degradation (e.g., a chemical degradation, a physical degradation, etc.) through mitigating interference sources. For the examples given, the interference sources can be associated with one of a cell, a module, a cell array, etc., within the used battery. Correspondingly, the estimation system 100 can accurately compute a SOF for a used battery during testing when reducing interference. The estimation system 100 can do so externally at a module level for internal cells while avoiding invasive and complex testing. Here, the first derivative nullifies, mitigates, eliminates, removes, etc., contact interference (e.g., iron contacts, copper contacts, etc.) for the used battery during impedance measurements at selected frequency bands. Contact interference may originate from internal cells within a battery module experiencing a loosening, tightening, etc., for a coupling between terminals, contact tabs, etc. The difference between the real-parts from the first derivatives of the impedance values among the two frequency points can nullify, mitigate, eliminate, remove, etc., inductive interference (e.g., iron-based induction).

In another example, the interference sources are an inductive interference from iron and a contact interference associated with one of a cell, a module, a cell array, etc., within the used battery. Furthermore, converting real-parts of impedance to a percentage value can minimize inductive interference (e.g., eddy current) and emphasize changes caused from metallic plating through observing linear relationships. This approach also reduces computations from taking advantage of monotonically increasing relationships.

In various implementations, the estimation system 100 includes an analysis algorithm that retrieves context parameters about the used battery. For instance, the estimation system 100 factors the context parameters and the difference between real-parts from first derivatives of impedance values among the two frequency points when selecting a threshold for the safety state and the residual value. Here, a system analyzing the residual value can diagnose other defects besides internal degradation, plating, etc. In one approach, the threshold is associated with a plating level involving a particular battery chemistry (e.g., lithium-ion), usage profile (e.g., harsh weather, rough terrain, aggressive driving, etc.), etc. In this way, the estimation system 100 increases the reliability and accuracy of the safety state and residual value outputs through intelligently selecting the threshold.

In another approach, the estimation system 100 estimates one of a safety state, a SOF, and the physical degradation for the used battery through computing eddy interference. Here, the estimation system 100 can utilize a linear relationship derived from first derivatives of real-parts associated with impedance measurements. This allows the estimation system 100 to diagnose the physical degradation as one of material wear and solid electrolyte interphase (SEI) growth. This also allows the estimation system 100 to diagnose an eddy current from inductive interference while avoiding complex testing tasks.

In the examples given herein, the estimation system 100 can also identify plating of a terminal within the used battery from a difference between two values of a first derivative within the frequency band using the testing equipment without disassembling cells associated with the used battery. Furthermore, the estimation system 100 can compute a safety state for the used battery without impedance tracking from a timepoint that the used battery is manufactured upon satisfaction of a cycling parameter. For instance, the cycling parameter represents a number of cycles and extreme operating temperatures experienced by the used battery. In this way, the estimation system 100 can output a safety state and a residual value about the used battery that indicates an available degree of the used battery being a power source in a reuse application.

In FIG. 2A, the estimation system 100 computes changes of first derivatives for real-parts between various interference sources $210_1$ to $210_3$ across different frequencies associated with impedance measurements. The estimation system 100 can do so by testing equipment non-invasively acquiring impedance measurements at a module level for a used battery pack. This avoids damage to access battery cells encountering the interference sources $210_1$ to $210_3$ during disassembly.

The interference source $210_1$ may represent plating associated with a cell within a used battery. The interference source $210_2$ can represent contact interference, contact interference plating, etc., associated with one of a battery module, a cell, etc. Contact interference may originate from internal cells within a battery module experiencing a loosening, tightening, etc., for a coupling between terminals. The interference source $210_3$ can represent a metal material external to the used battery effecting one of a battery module, a cell, etc., within the used battery. As such, the impedance changes of the first derivatives for the real-parts between two or more frequency points can indicate an interference source and related degrees. Furthermore, the estimation system 100 for the Y-axis in 220 converts to a percentage value and targets 20MHz for emphasizing degradation and plating effects within the used battery. This conversion can minimize contact interference and emphasize impedance changes from metallic plating (e.g., Li-plating) for detection by the estimation system 100.

In various implementations, FIG. 2B illustrates raw values of first derivatives for real-parts from impedance measurements using testing equipment. Here, the estimation system 100 derives the raw values from various batteries and compares the first derivative values for the real-parts against a threshold 230. As previously explained, the estimation system 100 can retrieve context parameters about the used battery and factor the context parameters and the difference between real-parts from first derivatives of impedance values when selecting a threshold. Here, the threshold 230 can indicate degrees when the safety state and the residual value allow a reuse application for a used battery. As such, the threshold 230 can be a plating level associated with one of a battery chemistry (e.g., lithium-ion), a usage profile (e.g., harsh weather, aggressive driving, etc.), etc.

As an example, the raw values over time for batteries 240 remain below the threshold 230 indicating that the batteries 240 have elevated residual values and free from plating. As such, systems have opportunities for reusing the used battery in diverse applications. Battery 250 can be available for reuse outside of mission-critical applications (e.g., residential) since the first derivative values for real-parts from impedance are near the threshold 230. This can also indicate a residual value that is limited and potential plating internally. Furthermore, the output of the estimation system 100 can indicate recycling battery 260 since the raw values of first derivative values are above the threshold 230. Here, the battery 260 may have one or more cells with metallic plating and other degradation (e.g., a chemical degradation, a physical degradation, etc.) to a degree that makes reuse impractical and unsafe. This also indicates that the battery 260 has a residual value that is minimal for reuse applications.

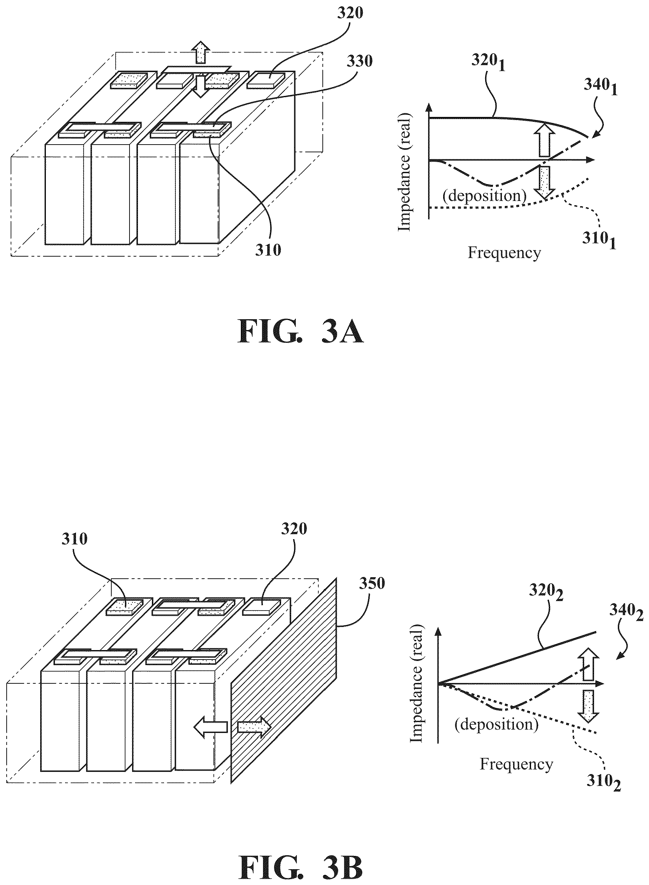

Regarding FIG. 3A and 3B, examples of interference sources the estimation system 100 can mitigate using first derivative computations are illustrated. As previously explained, the first derivative of the real-parts from impedance exhibits properties that allow the estimation system 100 to target one of metal deposition, a safety state, and degradation (e.g., a chemical degradation, a physical degradation, etc.) through mitigating interference sources for a used battery during testing. The safety state can involve extracting operating qualities over certain safety-related features of the used battery (e.g., a SOC, a temperature, induction, etc.). These interference sources can be associated with one of a cell, a module, a cell array, etc., within the used battery. The estimation system 100 avoids invasive and complex testing through the first derivative computations detecting the interference sources for internal cells externally at a module level. Furthermore, the estimation system 100 measuring impedance at target temperatures and SOCs exhibiting increased chemical reactivity can improve the effectiveness of detecting degradation and a residual value using first derivative computations. For instance, a target SOC is 20% for a residential reuse application that is non-critical while 85% for critical applications. These targets can depend upon internal architecture and chemistry of a used battery. As previously described, the estimation system 100 can adapt these targets for reuse applications involving the used battery, thereby further improving computational accuracy.

In many respects, the first derivative nullifies, mitigates, eliminates, removes, etc., contact interference for the used battery during impedance measurements involving selected frequency bands. Contact interference may be from internal cells within a battery module experiencing a loosening, tightening, etc., for a coupling between terminals that is readily measurable within a frequency band. In FIG. 3A, for example, the estimation system 100 mitigates contact interference when measuring impedance from a used battery. Here, the battery has a negative terminal 310 and a positive terminal 320 between internal cells, modules, etc., as contact tabs. Contact interference may be from the internal cells within a battery module experiencing a loosening, tightening, etc., for a coupling 330 between terminals, contact tabs, etc. The estimation system 100 can experience reduced reliability and accuracy from contact interference during impedance measurements. As such, the first derivative removing contact interference for the used battery during impedance measurements improves accuracy and reliability for detecting battery degradation and estimating a residual value and a safety state.

In FIG. 3A, the estimation system 100 may convert real-parts of impedance to a percentage value for minimizing inductive interference from eddy currents. This conversion can also magnify changes caused from metallic plating through observing linear relationships. This approach also reduces computational complexity from leveraging increasingly monotonic relationships. Furthermore, the estimation system 100 and the measurement module 130 can naturally filter wear interference and measurement noise (e.g., sensor interference) to the used battery by targeting certain frequency bands. Such frequency bands can be associated with the specific structure of the used battery. For instance, impedance measurements by the estimation system 100 are impacted by a used battery having one of cylindrically rolled cells, stacked plates, etc., below a certain frequency. As such, the estimation system 100 measuring above the certain frequency can remove the wear and aging interference through factoring battery structure.

In another example, FIG. 3B illustrates that the difference between the real-parts from the first derivatives of the impedance values among the two frequency points can nullify, mitigate, eliminate, remove, etc., inductive interference (e.g., iron-based induction). Here, an external object 350 that is metallic, magnetic, etc.,

causes inductive interference with internal cells, modules, a cell array, etc., during impedance measurements. For instance, the internal cells may comprise aluminum, stainless steel, etc., material that inductively couples with the external object 350 near the used battery. This coupling may occur even with polymers, plastic, etc., as the housing and shielding for a battery module. As such, the estimation system 100 removing inductive interference can improve computations for a safety state and a residual value including wear-related defects.

In one approach, the estimation system 100 detects mechanical deformation and a shift by module of the used battery from the inductive interference between the external object 350 and a contact tab associated with the module. This can include detecting a cell shift within the module between cells connected by the contact tab. The mechanical deformation can be caused by a collision involving the vehicle, an accident, an external force, impact, modules shifting, geometric cell changes, etc. Similar to plating, the estimation system 100 identifies and detects the mechanical deformation and the cell shift while avoiding invasive techniques that can damage battery hardware.

Charts $340_1$ and $340_2$ illustrate relationships between real-parts of impedance measurements with deposition on a cell contact (e.g., metallic plating). Here, curves $320_1$ and $320_2$ represent the real impedance for the positive terminal 320. Curves $310_1$ and $310_2$ represent the real impedance for the negative terminal 310. The charts $340_1$ and $340_2$ show factors that may change impedance which appear as interference against degradation (e.g., plating) and SOH estimation. Computing derivatives removes the impedance change caused by contact interference, inductive interference (e.g., iron-based induction), etc., to estimate SOS. Furthermore, removing and mitigation certain inferences allows the estimation system 100 to estimate SOS since the impedance change caused by SOS may be less than certain interference sources.

In various implementations, deposition from contact interference has first derivative values that are noticeable in chart $340_1$ at a higher frequency than in chart $340_2$. Furthermore, inductive interference from an external object that has iron and exhibits magnetic properties has constant first derivatives. In either case, the estimation system 100 can reliably detect deposition, a safety state, and a residual value above with a frequency, above a certain frequency, etc., that magnifies and emphasizes degradation and plating for a used battery. Therefore, the estimation system 100 can accurately estimate the safety state and residual value of cells within the used battery from the real values of the first derivative between various points along the frequency band non-invasively and reliably identify reuse applications for the used battery.

In another embodiment, the estimation system 100 executes second derivative computations of impedance (e.g., real-parts of impedance) over the frequency band. This enhances diagnosing internal plating at the module level while removing and mitigating additional interference sources than first derivative operations. For instance, the second derivative eliminates and zeroes out inductive interference from iron. This interference source has first-order characteristics that are constant allowing a second derivative computation of impedance to cancel the effect.

The second derivative also simplifies removing eddy current from induction as an interference source by making the effect constant. Here, the estimation system 100 can reliably differentiate between an eddy current and internal plating affecting impedance measurements by the measurement module 130 using second derivative computations along with first derivative computations. Furthermore, the estimation system 100 filters noise caused from derivative calculations. For example, the estimation system 100 factors cell arrangement and targets a frequency band having optimal characteristics that enhances plating effects. Similar to other approaches, this example involves comparing values of second derivatives from impedance measurements against a threshold for identifying internal plating of a battery cell, module, etc. In this way, the estimation system 100 accurately detects degradation of cells within the used battery from derivative computations within a target frequency band non-invasively while decreasing testing complexity and component damage.

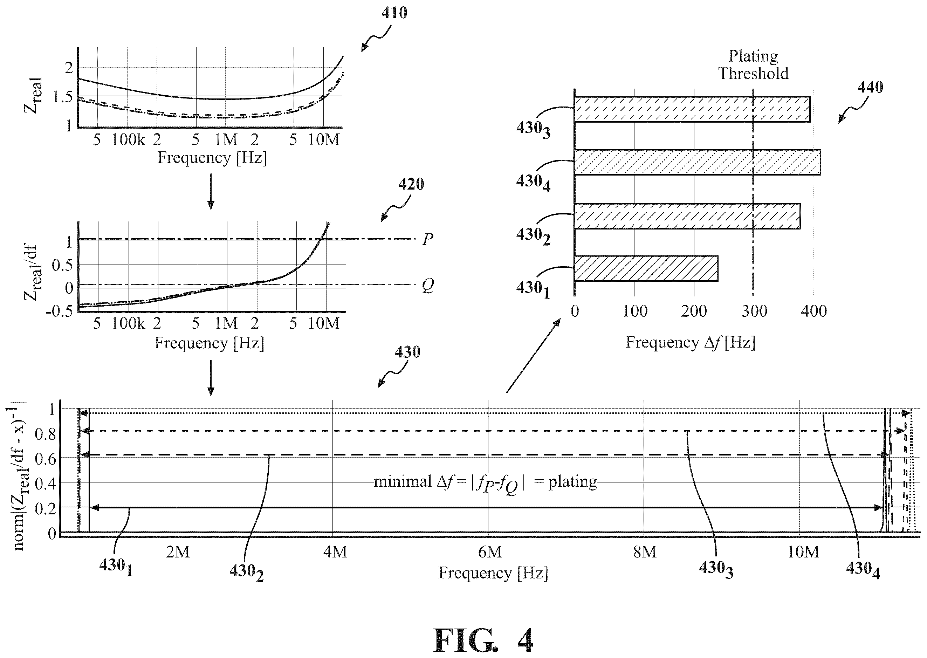

FIG. 4 illustrates another embodiment of detecting plating and determining a residual value using first derivative computations and multiple thresholds. Chart 410 illustrates that the measurement module 130 captures data for real-parts of impedance $Z_{real}$ from 5 Hz to 10 MHz operation of a battery module, a battery cell, etc. The estimation system 100 can derive the first derivative of the real-parts over frequency $Z_{real}/df$ for removing and mitigating interference sources within a battery module, a battery cell, etc. For instance, the interference sources are one of inductive interference from eddy currents, inductive interference from iron loss, resistive loss from contact interference, and normal aging and wear from charging/discharging cycles.

Chart 420 illustrates the estimation system 100 setting multiple thresholds $P$ and $Q$ related to detecting plating and comparing $Z_{real}/df$ from 5 Hz to 10 MHz. In one approach, the thresholds $P$ and $Q$ range from 0 and 1 and represent different interference sources. For instance, 0 represents contact interference that is reduced, eliminated, etc., through first derivative computations. Above 0 but below 1 can represent interference sources such as inductive interference from iron loss that exhibits constant first derivative values. Here, the estimation system 100 can read frequencies $f_P$ and $f_Q$ according to the thresholds $P$ and $Q$ for identifying plating degrees by operating frequency of a battery module, a battery cell, etc. For example, chart 430 exhibits the estimation system 100 deriving a threshold difference between frequencies $\Delta f$ using Equation (2):

$$\Delta f = |f_P - f_Q|. \quad \text{Equation (2)}.$$

Chart 430 illustrates the estimation system 100 evaluating data using Equation (2) through comparing norm$|(Z_{real}/df - x)^{-1}|$ against operating frequencies for a battery module, a battery cell, etc. Here, normalized (norm) difference $430_1$-$430_4$ (e.g., impedance, raw impedance, real impedance, etc.), between frequencies $f_P$ and $f_Q$ show various plating degrees. For instance, norm difference $430_1$ at 0.2 for $\Delta f$ indicates negligible, minimal, etc., plating for a frequency range $f_1$, thereby allowing reuse opportunities. Norm difference $430_2$ at 0.6 for $\Delta f$ indicates moderate plating for a frequency range $f_2$, thereby allowing limited applications for reuse (e.g., residential backup power). Norm difference $430_3$ at 0.8 for $\Delta f$ indicates elevated plating for a frequency range $f_3$. Lastly, norm difference $430_4$ at 1 for $\Delta f$ indicates dangerous plating for a frequency range $f_4$. As such, norm differences $430_3$ and $430_4$ indicate that a battery module, a battery cell, etc., should be recycled rather than reused.

In 440, the estimation system 100 evaluates the norm differences $430_1$-$430_4$ between frequencies $f_P$ and $f_Q$ against a plating threshold for various $\Delta f$ values. For example, norm differences $430_1$ and $430_2$ indicate that a battery module, a battery cell, etc., may be reused in certain second-life applications. However, norm differences $430_3$ and $430_4$ indicate that a battery module, a battery cell, etc., should be recycled. Accordingly, the estimation system 100 using multiple thresholds for first derivative values of real-parts associated with measured impedance and normalizing about various frequency bands improves identifying plating and designating a battery module for reuse or recycling while avoiding invasive testing and measurements.

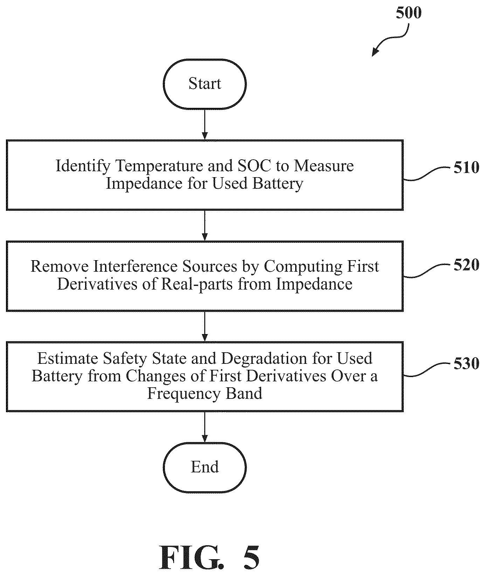

Now discussing FIG. 5, a flowchart of a method 500 that is associated with estimating a safety state and degradation for the used battery from changes of first derivatives over a frequency band is illustrated. Method 500 will be discussed from the perspective of the estimation system of FIG. 1. While the method 500 is discussed in combination with the estimation system 100, it should be appreciated that the method 500 is not limited to being implemented within the estimation system 100 but is instead one example of a system that may implement the method 500.

At 510, the estimation system 100 and the measurement module 130 identify a temperature and SOC to measure the impedance of a used battery. As previously explained, the measurement module 130 of testing equipment can measure the impedance within a target frequency band that emphasizes and enhances interference sources. This allows the estimation system 100 to remove the interference sources by computing first derivatives of real-parts from the impedance. Furthermore, the estimation system 100 estimates a safety state and a degradation (e.g., a chemical degradation, a physical degradation, etc.) for the used battery from changes of the first derivatives within a frequency band.

Furthermore, the estimation system 100 measuring impedance at target temperatures and SOCs parameters improves the effectiveness of computing a safety state and detecting degradation using first derivative computations. These parametric targets can depend upon the internal architecture and chemistry profile of a used battery. As such, the estimation system 100 can adapt these parametric targets for reuse applications during impedance measurements involving the used battery, thereby improving computational accuracy.

In various implementations, the estimation system 100 includes testing equipment that measures impedance at a module level for a used battery and executes computations involving first derivatives of the impedance. In this way, the estimation system 100 removes interference sources having first derivative properties for impedance that are unchanged and negligible (e.g., zero). This also allows estimating a safety state and degradation (e.g., a chemical degradation, a physical degradation, etc.) for a cell, a cell array, etc., within a module of a used battery without invasive dissembling and expensive equipment, thereby reducing system complexity.

At 520, the estimation system 100 removes interference sources by computing first derivatives of real-parts from the impedance. As previously explained, the first derivative of the real-parts from impedance exhibits properties that allow the estimation system 100 to target metal deposition and degradation through mitigating interference sources. This allows the estimation system 100 to accurately compute a safety state, a SOF, a residual value, etc., for a used battery during testing. Here, the interference sources can be associated with one of a cell, a module, a cell array, etc., within the used battery. Furthermore, the estimation system 100 can do so externally at a module level for internal cells while avoiding invasive and complex testing.

In one approach, the first derivative nullifies, mitigates, eliminates, removes, etc., contact interference and inductive inference for the used battery during impedance measurements at selected frequency bands. Contact interference may originate from internal cells within a battery module experiencing a loosening, tightening, etc., for a coupling. This coupling can occur between terminals, contact tabs, etc., of one or more cells. The difference between the real-parts from the first derivatives of the impedance values among the two frequency points can nullify, mitigate, eliminate, remove, etc., inductive interference (e.g., iron-based induction).

In another approach, converting real-parts of impedance to a percentage value can minimize inductive interference (e.g., eddy current) and emphasize changes caused from metallic plating through observing linear relationships. As previously explained, this approach also leverages monotonically increasing relationships for interference sources that reduce computations.

At 530, the estimation system 100 estimates a safety state and a degradation for the used battery from changes of the first derivatives over a frequency band. Here, the frequency band for impedance measurements exceeds a frequency where the ion response inside the battery is dominant. This allows the estimation system 100 to accurately diagnose causes of impedance changes from impedance values and a first derivative for a frequency, such as variable frequencies $f_1$ to $f_2$. A diagnosis can include the safety state associated with one of lithium metal deposition, lithium plating inside a battery cell, etc., when the values of first derivatives for real-parts from impedance measurements exceed a threshold. As previously explained, the threshold can be associated with a plating level involving a particular battery chemistry (e.g., lithium-ion), usage profile (e.g., harsh weather, rough terrain, aggressive driving, etc.), etc.

Moreover, degradation can include determining a residual value, a SOF, a state of functionality, etc., associated with a used battery for reuse applications. The safety state exceeding a minimal parameter, threshold, etc., can indicate that a cell, a cell array, etc., within the used battery exhibits sparse metallic plating, thereby increasing opportunities for reuse rather than recycling. Otherwise, the safety state may indicate that the used battery is unsuitable and unsafe for reuse opportunities and the used battery should be recycled.

In various implementations, the estimation system 100 computes changes of first derivatives for real-parts between various interference sources across different frequencies associated with impedance measurements. The estimation system 100 can do so by testing equipment non-invasively acquiring impedance measurements at a module level for a used battery pack. In this way, the estimation system 100 avoids damage to access battery cells encountering the interference sources during disassembly.

Another example includes the estimation system 100 executing second derivative computations of impedance (e.g., real-parts of impedance) over the frequency band. This allows diagnosing internal plating at the module level while removing and mitigating additional interference sources than first derivative operations. Here, at 520 the estimation system 100 can compute the second derivative for eliminating and zeroing out inductive interference from iron since the first-order of this interference source is constant. The second derivative also simplifies removing eddy current from induction as an interference source by making the effect constant.

Moreover, at 530 the estimation system 100 filters noise caused from derivative calculations, such as through factoring cell arrangement and targeting a frequency band having optimal characteristics that enhance plating effects for testing. Here, the estimation system 100 estimates a safety state and a degradation for the used battery from changes of the second derivatives over the frequency band. For instance, the frequency band for impedance measurements exceeds a frequency where the ion response inside the battery is dominant associated with certain interference sources. In this way, the estimation system 100 can accurately diagnose causes of impedance changes from impedance values and a first derivative for a frequency, such as variable frequencies $f_1$ to $f_2$. Similar to other approaches, this example involves comparing values of second derivatives from impedance measurements against a threshold for identifying internal plating of a battery cell, module, etc. Therefore, the estimation system 100 accurately detects the safety state and degradation of cells within the used battery from derivative computations within a target frequency band while using non-invasive measures that also reduce testing complexity and component damage.

Detailed embodiments are disclosed herein. However, it is to be understood that the disclosed embodiments are intended as examples. Therefore, specific structural and functional details disclosed herein are not to be interpreted as limiting, but merely as a basis for the claims and as a representative basis for teaching one skilled in the art to variously employ the aspects herein in virtually any appropriately detailed structure. Furthermore, the terms and phrases used herein are not intended to be limiting but rather to provide an understandable description of possible implementations. Various embodiments are shown in FIGS. 1-4, but the embodiments are not limited to the illustrated structure or application.

The flowcharts and block diagrams in the figures illustrate the architecture, functionality, and operation of possible implementations of systems, methods, and computer program products according to various embodiments. In this regard, a block in the flowcharts or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved.

The systems, components, and/or processes described above can be realized in hardware or a combination of hardware and software and can be realized in a centralized fashion in one processing system or in a distributed fashion where different elements are spread across several interconnected processing systems. Any kind of processing system or another apparatus adapted for carrying out the methods described herein is suited. A typical combination of hardware and software can be a processing system with computer-usable program code that, when being loaded and executed, controls the processing system such that it carries out the methods described herein.

The systems, components, and/or processes also can be embedded in a computer-readable storage, such as a computer program product or other data programs storage device, readable by a machine, tangibly embodying a program of instructions executable by the machine to perform methods and processes described herein. These elements also can be embedded in an application product which comprises the features enabling the implementation of the methods described herein and, which when loaded in a processing system, is able to carry out these methods.

Furthermore, arrangements described herein may take the form of a computer program product embodied in one or more computer-readable media having computer-readable program code embodied, e.g., stored, thereon. Any combination of one or more computer-readable media may be utilized. The computer-readable medium may be a computer-readable signal medium or a computer-readable storage medium. The phrase "computer-readable storage medium" means a non-transitory storage medium. A computer-readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer-readable storage medium would include the following: a portable computer diskette, a hard disk drive (HDD), a solid-state drive (SSD), a ROM, an EPROM or flash memory, a portable compact disc read-only memory (CD-ROM), a digital versatile disc (DVD), an optical storage device, a magnetic storage device, or any suitable combination of the foregoing. In the context of this document, a computer-readable storage medium may be any tangible medium that can contain, or store a program for use by or in connection with an instruction execution system, apparatus, or device.

Generally, modules as used herein include routines, programs, objects, components, data structures, and so on that perform particular tasks or implement particular data types. In further aspects, a memory generally stores the noted modules. The memory associated with a module may be a buffer or cache embedded within a processor, a RAM, a ROM, a flash memory, or another suitable electronic storage medium. In still further aspects, a module as envisioned by the present disclosure is implemented as an ASIC, a hardware component of a system on a chip (SoC), as a programmable logic array (PLA), or as another suitable hardware component that is embedded with a defined configuration set (e.g., instructions) for performing the disclosed functions.

Program code embodied on a computer-readable medium may be transmitted using any appropriate medium, including but not limited to wireless, wireline, optical fiber, cable, radio frequency (RF), etc., or any suitable combination of the foregoing. Computer program code for carrying out operations for aspects of the present arrangements may be written in any combination of one or more programming languages, including an object-oriented programming language such as Java™, Smalltalk™, C++, or the like and conventional procedural programming languages, such as the "C" programming language or similar programming languages. The program code may execute entirely on the user's computer, partly on the user's computer, as a stand-alone software package, partly on the user's computer and partly on a remote computer, or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

The terms "a" and "an," as used herein, are defined as one or more than one. The term "plurality," as used herein, is defined as two or more than two. The term "another," as used herein, is defined as at least a second or more. The terms "including" and/or "having," as used herein, are defined as comprising (i.e., open language). The phrase "at least one of ... and ...." as used herein refers to and encompasses any and all combinations of one or more of the associated listed items. As an example, the phrase "at least one of A, B, and C" includes A, B, C, or any combination thereof (e.g., AB, AC, BC, or ABC).

Aspects herein can be embodied in other forms without departing from the spirit or essential attributes thereof. Accordingly, reference should be made to the following claims, rather than to the foregoing specification, as indicating the scope hereof.

## Claims

1. An estimation system, comprising:
   a memory storing instructions that, when executed by a processor, cause the processor to:

   identify a temperature and a state of charge (SOC) by testing equipment to measure impedance for a used battery from a vehicle;
   remove interference sources by computing first derivatives of real-parts from the impedance and factoring the temperature and the SOC, and the testing equipment measures the impedance;
   estimate a safety state and a physical degradation for the used battery from changes of the first derivatives within a frequency band; and
   upon the safety state satisfying a parameter, draw power from the used battery by a device during a reuse operation.

2. The estimation system of claim 1, wherein the instructions to estimate the safety state and the physical degradation for the used battery further include instructions to:

   compute eddy interference using a linear relationship derived from the first derivatives;
   identify plating of a terminal within the used battery from a difference between two values of a first derivative within the frequency band using the testing equipment without dissembling cells associated with the used battery; and
   output an indication of the plating and a residual value about the used battery, the residual value indicates a degree of the used battery being a power source in a reuse application.

3. The estimation system of claim 1, wherein the instructions to remove the interference sources further includes instructions to:
   mitigate inductive interference from iron by computing second derivatives from the impedance over the frequency band.

4. The estimation system of claim 1, wherein the instructions of the safety state satisfying the parameter further include instructions to:
   diagnose the physical degradation as one of material wear and an eddy current from inductive interference.

5. The estimation system of claim 1 further including instructions to:
   detect mechanical deformation and a cell shift within a module of the used battery from inductive interference between an external object that is metallic and a contact tab within the module, wherein the mechanical deformation is associated with a collision involving the vehicle.

6. The estimation system of claim 1 further including instructions to:
   compute a functionality state for the used battery using the safety state and a weighting factor, and the functionality state is a residual value of the used battery as a power source in a reuse application.

7. The estimation system of claim 1, wherein the instructions to identify the temperature and the SOC by testing equipment further includes instructions to:

   select the frequency band according to a cell layout of the used battery; and
   filter wear interference to the used battery using the frequency band.

8. The estimation system of claim 1, wherein the instructions to estimate the safety state and the physical degradation for the used battery further include instructions to:

compare the first derivatives within the frequency band against a first threshold and a second threshold;

calculate a threshold difference between the first threshold and the second threshold for frequency points within the frequency band using normalized values of the first derivatives;

upon the threshold difference satisfying a plating threshold, identify plating as the physical degradation; and

wherein the interference sources are an inductive interference from iron and a contact interference associated with one of a cell and a module within the used battery; and

wherein the SOC is one of a charge level and a discharge level associated with chemical degradation.

9. The estimation system of claim 1, wherein:

the safety state indicates plating within a cell of a module internal to the used battery;

the frequency band is above a frequency having increased chemical breakdown and an ion response that is elevated associated with the used battery; and

the parameter indicates that one of a cell and the module internally within the used battery has undetected plating on a surface of an anode associated with a threshold.

10. A non-transitory computer-readable medium comprising:

instructions that when executed by a processor cause the processor to:

identify a temperature and a state of charge (SOC) by testing equipment to measure impedance for a used battery from a vehicle;

remove interference sources by computing first derivatives of real-parts from the impedance and factoring the temperature and the SOC, and the testing equipment measures the impedance;

estimate a safety state and a physical degradation for the used battery from changes of the first derivatives within a frequency band; and

upon the safety state satisfying a parameter, draw power from the used battery by a device during a reuse operation.

11. The non-transitory computer-readable medium of claim 10, wherein the instructions to estimate the safety state and the physical degradation for the used battery further include instructions to:

compute eddy interference using a linear relationship derived from the first derivatives;

identify plating of a terminal within the used battery from a difference between two values of a first derivative within the frequency band using the testing equipment without dissembling cells associated with the used battery; and

output an indication of the plating and a residual value about the used battery, the residual value indicates a degree of the used battery being a power source in a reuse application.

12. A method comprising:

identifying a temperature and a state of charge (SOC) by testing equipment to measure impedance for a used battery from a vehicle;

removing interference sources by computing first derivatives of real-parts from the impedance and factoring the temperature and the SOC, and the testing equipment measures the impedance;

estimating a safety state and a physical degradation for the used battery from changes of the first derivatives within a frequency band; and

upon the safety state satisfying a parameter, drawing power from the used battery by a device during a reuse operation.

13. The method of claim 12, wherein estimating the safety state and the physical degradation for the used battery further includes:

computing eddy interference using a linear relationship derived from the first derivatives;

identifying plating of a terminal within the used battery from a difference between two values of a first derivative within the frequency band using the testing equipment without dissembling cells associated with the used battery; and

outputting an indication of the plating and a residual value about the used battery, the residual value indicates a degree of the used battery being a power source in a reuse application.

14. The method of claim 12, wherein removing the interference sources further includes:

mitigating inductive interference from iron by computing second derivatives from the impedance over the frequency band.

15. The method of claim 12, wherein the safety state satisfying the parameter further includes:

diagnosing the physical degradation as one of material wear and an eddy current from inductive interference.

16. The method of claim 12 further comprising:

detecting mechanical deformation and a cell shift within a module of the used battery from inductive interference between an external object that is metallic and a contact tab within the module, wherein the mechanical deformation is associated with a collision involving the vehicle.

17. The method of claim 12 further comprising: computing a functionality state for the used battery using the safety state and a weighting factor, and the functionality state is a residual value of the used battery as a power source in a reuse application.

18. The method of claim 12, wherein identifying the temperature and the SOC by testing equipment further includes:

   selecting the frequency band according to a cell layout of the used battery; and
   filtering wear interference to the used battery using the frequency band.

19. The method of claim 12, wherein estimating the safety state and the physical degradation for the used battery further includes:

   comparing the first derivatives within the frequency band against a first threshold and a second threshold;
   calculating a threshold difference between the first threshold and the second threshold for frequency points within the frequency band using normalized values of the first derivatives;
   upon the threshold difference satisfying a plating threshold, identifying plating as the physical degradation; and
   wherein the interference sources are an inductive interference from iron and a contact interference associated with one of a cell and a module within the used battery; and
   wherein the SOC is one of a charge level and a discharge level associated with chemical degradation.

20. The method of claim 12, wherein:

   the safety state indicates plating within a cell of a module internal to the used battery;
   the frequency band is above a frequency having increased chemical breakdown and an ion response that is elevated associated with the used battery; and
   the parameter indicates that one of a cell and the module internally within the used battery has undetected plating on a surface of an anode associated with a threshold.

FIG. 1

FIG. 2A

**FIG. 2B**

**FIG. 3A**

**FIG. 3B**

**FIG. 4**

**500**

```
           ┌─────────┐
           │  Start  │
           └─────────┘
                │
                ▼
  ┌─────────────────────────────────┐
  │  Identify Temperature and SOC   │      510
  │  to Measure Impedance for Used  │
  │            Battery              │
  └─────────────────────────────────┘
                │
                ▼
  ┌─────────────────────────────────┐
  │ Remove Interference Sources by  │      520
  │ Computing First Derivatives of  │
  │    Real-parts from Impedance    │
  └─────────────────────────────────┘
                │
                ▼
  ┌─────────────────────────────────┐
  │ Estimate Safety State and       │      530
  │ Degradation for Used Battery    │
  │ from Changes of First           │
  │ Derivatives Over a Frequency    │
  │ Band                            │
  └─────────────────────────────────┘
                │
                ▼
           ┌─────────┐
           │   End   │
           └─────────┘
```

# FIG. 5

Europäisches
Patentamt
European
Patent Office
Office européen
des brevets

# EUROPEAN SEARCH REPORT

**Application Number**

EP 25 21 8259

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2024/094308 A1 (YOSHIDA SHUHEI [JP] ET AL) 21 March 2024 (2024-03-21)<br>* paragraph [0051] - paragraph [0057] *<br>* paragraph [0086] - paragraph [0101] *<br>* figures 2, 5-6, 9-12 *<br>----- | 1-20 | INV.<br>G01R31/389<br>G01R31/392 |
| A | US 2025/025002 A1 (WARD II JIMMIE B [US]) 23 January 2025 (2025-01-23)<br>* paragraph [0096] - paragraph [0099] *<br>* figures 14-16 *<br>----- | 1-20 | |
| A | US 2023/042256 A1 (SCHMIDT JAN PHILIPP [DE]) 9 February 2023 (2023-02-09)<br>* paragraph [0056] - paragraph [0071] *<br>* paragraph [0085] - paragraph [0091] *<br>* figures 1-7 *<br>----- | 1-20 | |
| A | US 2022/239128 A1 (LEE BOHYUN [KR] ET AL) 28 July 2022 (2022-07-28)<br>* paragraph [0022] - paragraph [0024] *<br>* paragraph [0092] - paragraph [0141] *<br>----- | 1-20 | |

**TECHNICAL FIELDS SEARCHED (IPC)**

G01R

The present search report has been drawn up for all claims

| Place of search | Date of completion of the search | Examiner |
|---|---|---|
| Munich | 11 May 2026 | Paraf, Edouard |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 21 8259

This annex lists the patent family members relating to the patent documents cited in the above-mentioned European search report.
The members are as contained in the European Patent Office EDP file on
The European Patent Office is in no way liable for these particulars which are merely given for the purpose of information.

11-05-2026

| Patent document cited in search report | Publication date | Patent family member(s) | Publication date |
|---|---|---|---|
| US 2024094308 A1 | 21-03-2024 | CN 117741460 A<br>JP 2024044887 A<br>US 2024094308 A1 | 22-03-2024<br>02-04-2024<br>21-03-2024 |
| US 2025025002 A1 | 23-01-2025 | NONE | |
| US 2023042256 A1 | 09-02-2023 | CN 114556737 A<br>DE 102019133921 A1<br>EP 4073874 A1<br>JP 7644757 B2<br>JP 2023505750 A<br>KR 20220057559 A<br>US 2023042256 A1<br>WO 2021115694 A1 | 27-05-2022<br>17-06-2021<br>19-10-2022<br>12-03-2025<br>13-02-2023<br>09-05-2022<br>09-02-2023<br>17-06-2021 |
| US 2022239128 A1 | 28-07-2022 | CN 114814627 A<br>DE 102021214711 A1<br>KR 20220108318 A<br>US 2022239128 A1 | 29-07-2022<br>28-07-2022<br>03-08-2022<br>28-07-2022 |

EPO FORM P0459

For more details about this annex : see Official Journal of the European Patent Office, No. 12/82